# EUROPEAN PATENT APPLICATION

(11) **EP 3 748 692 A1**
(43) Date of publication of application: **09.12.2020**
(21) Application number: 18769274.4
(22) Date of filing: 12.07.2018
(51) Int. Cl.: H01L 31/0224

(54) **MANUFACTURING METHOD OF THIN FILM SOLAR CELL**

(30) Priority: 01.02.2018 CN 201810102469
(71) Applicant: Beijing Apollo Ding Rong Solar Technology Co., Ltd, Beijing 100176 (CN)
(72) Inventor: ZHAO, Shuli, Beijing 100176 (CN); GUO, Lida, Beijing 100176 (CN); LI, Xinlian, Beijing 100176 (CN); CHEN, Tao, Beijing 100176 (CN); YANG, Lihong, Beijing 100176 (CN)
(74) Representative: Cohausz & Florack
(86) International application number: PCT/CN2018/095476
(87) International publication number: WO 2019/148774

(57) **Abstract**

The present disclosure provides a preparation method of a thin film solar battery, including the following steps: a) performing a first etching of the back electrode layer to form a plurality of first grooves; b) forming an insulator in each of the plurality of first grooves, thereby forming a plurality of insulators; c) forming a light absorption layer and a buffer layer sequentially on a surface of the back electrode layer, performing a second etching of the light absorption layer and the buffer layer to form a plurality of second grooves; and d) forming an upper electrode layer on a surface of the buffer layer, the upper electrode layer extending to the plurality of second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells.

## Description

This application claims priority to Chinese Patent Application No. 201810102469.4, filed with the Chinese patent office on February 01, 2018, titled "PREPARATION METHOD OF THIN FILM SOLAR BATTERY COMPONENT", which is incorporated herein by reference in its entirety.

### TECHNICAL FIELD

The present disclosure relates to a technical field of solar battery, more particularly, to a preparation method of a thin film solar battery.

### BACKGROUND

Thin film solar battery, also called "solar chip" or "photocell", is an optoelectronic semiconductor component that generates electricity directly by using sunlight.

Some of the steps in preparation process of a thin film solar battery are: dividing a whole piece of thin film solar battery into a plurality of battery cells by using a laser/mechanical etching process (named P1 etching, P2 etching, and P3 etching respectively in a etching sequence) at least 3 times, and enabling serial or parallel connections between the plurality of battery cells. This process design can ensure the thin film solar battery to realize output at suitable voltage and current, so as to implement practical application of the thin film solar battery.

### SUMMARY

Embodiments of the present disclosure provide a preparation method of a thin film solar battery, including the following steps:
a) providing a substrate and forming a back electrode layer thereon, and performing a first etching of the back electrode layer to form a plurality of first grooves on the back electrode layer, the plurality of first grooves all passing through the back electrode layer;
b) forming an insulator in each of the plurality of first grooves, thereby forming a plurality of insulators;
c) forming a light absorption layer and a buffer layer sequentially on a surface of the back electrode layer formed with the plurality of insulators, and performing a second etching of the light absorption layer and the buffer layer to form a plurality of second grooves, the plurality of second grooves all passing through the light absorption layer and the buffer layer; and
d) forming an upper electrode layer on a surface of the buffer layer, the upper electrode layer extending to the plurality of second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells.

### BRIEF DESCRIPTION OF THE DRAWINGS

The accompanying drawings are used to provide further understanding of the disclosure and constitute a part of the present disclosure. The following exemplary embodiments together with the explanation thereof serve to explain the present disclosure, but do not constitute an improper limitation to the disclosure. In the accompanying drawings:
Fig. 1 is a schematic diagram illustrating a structure of a thin film solar battery in the present disclosure; and
Fig. 2 is a schematic diagram illustrating a preparation process of a thin film solar battery in the present disclosure.

### DETAILED DESCRIPTION

The technical solutions in the embodiments of the present disclosure will be described clearly and completely. Obviously, the described embodiments are merely some but not all of embodiments of the present disclosure. All other embodiments made on the basis of the embodiments of the present disclosure by a person of ordinary skill in the art without paying any creative effort shall be included in the protection scope of the present disclosure.

Although a plurality of serial/parallel battery cells can be formed in the P1, P2, and P3 etching processes, regions disabling photoelectrical conversion (including regions that corresponds to etching lines of the P1, P2, and P3 etching processes and spaced regions between adjacent etching lines thereof), i.e., the so-called "dead zone" in the thin film solar battery, will be produced on the thin film solar battery.

The P1, P2 and P3 etching processes are implemented by the laser or mechanical etching, which is limited by the technical level of the existing etching process and the cost control factors, so the width and accuracy of P1-P3 etching lines are hard to improve significantly, causing a difficulty in effective reduction of an area of the dead zone , and finally affecting the light conversion efficiency of the thin film solar battery.

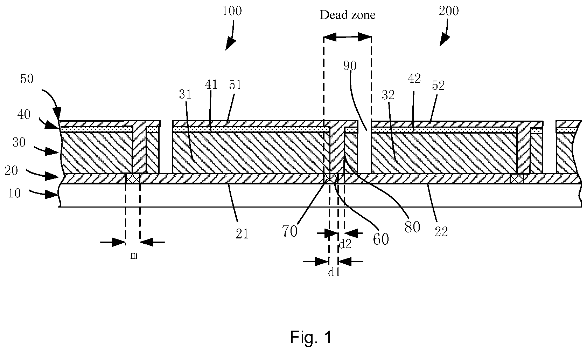

Referring to Fig. 1, some embodiments of the present disclosure provide a thin film solar battery. The thin film solar battery comprises a substrate 10 and a plurality of serial battery cells disposed in interval on the substrate 10. Each of the plurality of battery cells comprises a back electrode layer 20, a light absorption layer 30, a buffer layer 40, and an upper electrode layer 50 disposed sequentially. A first groove 60 passing through the back electrode layer 20 is disposed between the back electrode layers 20 of any two adjacent battery cells in the plurality of battery cells. The first groove 60 is filled with an insulator 70, such that the back electrode layers 20 of the two adjacent battery cells are insulated from each other. Each of the plurality of battery cells is provided with a second groove 80 passing through the light absorption layer 30 and the buffer layer 40. The upper electrode layer 50 of one battery cell covers the buffer layer 40 of the one battery cell and extends to the second groove 80 of the one battery cell, so as to contact the back electrode layer 20 of another adjacent battery cell, thereby serially connecting the two adjacent battery cells. A third groove 90 is arranged between any two adjacent battery cells, and the third groove 90 insulates the upper electrode layers 50 of the two adjacent battery cells from each other.

The thin film solar battery has the following advantages: since the first groove 60 is provided with the insulator 70, the second groove 80 can be formed above a partial surface of the insulator 70, i.e., the position of the second groove 80 partially overlaps the position of the first groove 60 therefore the spacing distance between the second groove 80 and the first groove 60 is reduced. The area of the dead zone is greatly reduced in this manner, and thereby the conversion efficiency of the thin film solar battery component is greatly improved.

In some embodiments of the present disclosure, the insulator 70 is arranged at a position where the first etching line (i.e., P1 etching) of the thin film solar battery is located, so as to perform a second etching (i.e., P2 etching) at a corresponding position of a partial surface of the insulator 70, thereby reducing the area of the dead zone.

In a preparation method of the thin film solar battery provided in some embodiments of the present disclosure, the first groove 60 is formed in the first etching process, and the insulator 70 is formed via a mask in the first groove 60, so as to perform a second etching process at a corresponding position of a partial surface of the insulation section 70. Thus the spacing distance between the position of the first etching process and the position of the second etching process is reduced, and accordingly the area of the dead zone is greatly reduced. This method also has the advantages of simple process, high efficiency, and controllability.

Referring to Fig. 1, a first battery cell 100 and a second battery cell 200 disposed adjacent to each other in the thin film solar battery are used as an example below to describe the structure of the thin film solar battery.

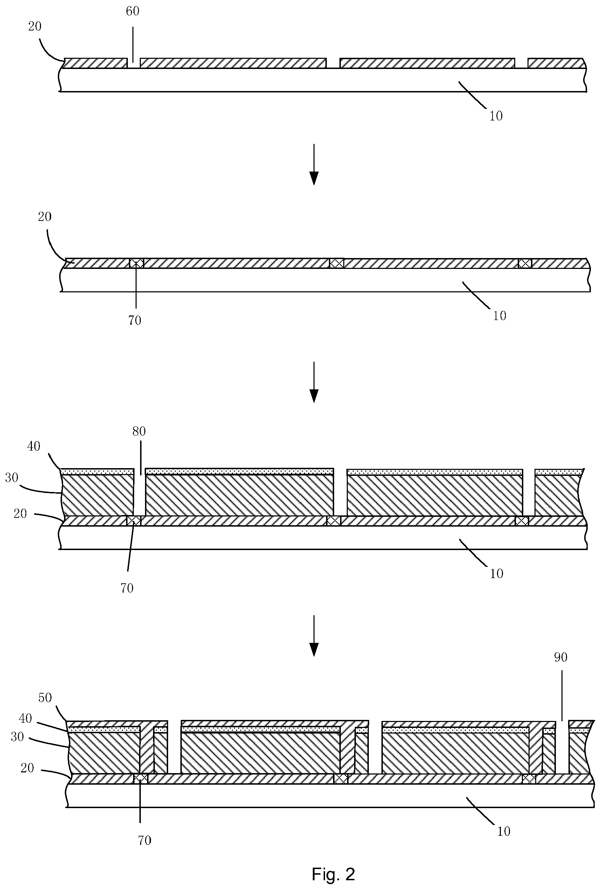

The first battery cell 100 and the second battery cell 200 are adjacent to each other and have the same structure. That is, the first battery cell 100 and the second battery cell 200 are actually repetitive battery cells with the same structure, and they are named differently only for the purpose of better explaining the relationship between the elements in the two adjacent battery cells. The first battery cell 100 comprises a first back electrode layer 21, a first light absorption layer 31, a first buffer layer 41, and a first upper electrode layer 51 arranged sequentially. The second battery cell 200 comprises a second back electrode layer 22, a second light absorption layer 32, a second buffer layer 42, and a second upper electrode layer 52 arranged sequentially. The first battery cell 100 and the second battery cell 200 share the substrate 10. The first back electrode layer 21 and the second back electrode layer 22 are isolated from each other by the insulator 70. Referring to Fig. 2, the first light absorption layer 31 and the first buffer layer 41 have the second groove 80 in a direction of thicknesses of the first light absorption layer 31 and the first buffer layer 41 and passing through the first light absorption layer 31 and the first buffer layer 41. Referring to Fig. 1, the first upper electrode layer 51 covers the first buffer layer 41 and extends to the second groove 80 to cover a part of the second back electrode layer 22, so as to electrically connect the second back electrode layer 22, i.e., the first battery cell 100 and the second battery cell 200 are electrically connected with each other in series.

In some embodiments of the present disclosure, a portion of the first upper electrode layer 51 that extends to the second groove 80 covers the insulator 70. In some other embodiments of the present disclosure, a portion of the first upper electrode layer 51 that extends to the second groove 80 does not cover the insulator 70. That is, the first groove 60 formed by the first etching (P1 etching) and the second groove 80 may or may not overlap.

In some embodiments of the present disclosure, a portion of the back electrode layer and a portion of each of the plurality of insulation sections are exposed from the bottom of each of the plurality of second grooves.

In some embodiments of the present disclosure, as shown in Fig. 1, the bottom of the second groove 80 of the first battery cell 100 is located at a boundary between the insulator 70 of the first battery cell 100 and the back electrode layer 22 of the adjacent second battery cell 200, and the upper electrode layer 51 located in the second groove 80 covers partial insulator 70 of the first battery cell 100 and partial back electrode layer 22 of the adjacent second battery cell 200. At this time, the upper electrode layer 51 is extended to the second groove 80, and a width of the portion overlapping the insulator 70 is expressed by d1. A width of the insulator 70 is expressed by m. In some embodiments of the present disclosure, m and d1 satisfy the condition below: m>d1>0. The reason why m>d1 is defined is that if the portion of the first upper electrode layer 51 that extends to the second groove 80 comes into contact with the first back electrode layer 21, a short circuit will occur. In some embodiments, m and d1 satisfy the condition below: m-d1≥30µm, which can better avoid such short circuits. The insulator 70 isolates and thereby insulates the first back electrode layer 21 from the second back electrode layer 22, thus achieving relative independence between the first battery cell 100 and the second battery cell 200. In some embodiments of the present disclosure, the width m of the insulator 70 satisfies the condition below: 30µm≤m≤60µm, which can achieve a better insulation effect.

In some embodiments of the present disclosure, material of the insulator 70 includes at least one of Si₃N₄, AIN, SiO₂, and Al₂O₃. For example, the material of the insulator 70 is Si₃N₄. In some other embodiments of the present disclosure, material of the insulator 70 includes more than one of Si₃N₄, AIN, SiO₂ and Al₂O₃. For example, the material of the insulator 70 is a compound film of Si₃N₄ and SiO₂.

A width of the second groove 80 may be of any size. In some embodiments of the present disclosure, however, to better connect with electrodes (such as electrodes in the back electrode layer and the upper electrode layer) and considering reducing the size of the dead zone, the width of the second groove 80 is 50µm∼80µm, which may better connect with the electrodes and reduce the size of the dead zone.

In some embodiments of the present disclosure, the first battery cell 100 and the second battery cell 200 are isolated from each other by the third groove 90. The third groove 90 isolates the first upper electrode layer 51 from the second upper electrode layer 52, isolates the first buffer layer 41 from the second buffer layer 42, and isolates the first light absorption layer 31 from the second light absorption layer 32.

The third groove 90 cooperates with the insulator 70 to achieve "relative independence" between the first battery cell 100 and the second battery cell 200. The reason why we say "relative independence" is that the first upper electrode layer 51 in the second groove 80 realizes a serial connection between the first battery cell 100 and the second battery cell 200.

The substrate 10 may be made from any material, including glass, stainless steel, and flexible material. A thickness of the substrate 10 is also not limited. The substrate 10 plays a role of supporting the solar battery.

Material of the back electrode layer 20 may be Mo, Ti, Cr, Cu, or the back electrode layer 20 may be a transparent conductive layer. The transparent conductive layer includes one or more of aluminum-doped zinc oxide (AZO), boron-doped zinc oxide (AZO), and indium-doped tin oxide (ITO). A thickness of the back electrode layer 20 may not be limited. In some embodiments of the present disclosure, the thickness of the back electrode layer 20 is 200nm∼800nm. In some other embodiments of the present disclosure, the thickness of the insulator 70 is the same as the thickness of the back electrode layer 20. In some other embodiments of the present disclosure, the thickness of the insulator 70 is greater than the thickness of the back electrode layer 20 to effectively avoid a formation of a short circuit.

Material of the light absorption layer 30 is one of copper indium gallium selenium, copper indium selenium, and copper indium gallium sulfur. A thickness of the light absorption layer 30 may not be limited, and in some embodiments of the present disclosure, it may be 0.5µm∼3µm.

Material of the buffer layer 40 is one of zinc sulfide, cadmium sulfide and indium sulfide. A thickness of the buffer layer 40 may not be limited, and in some embodiments, it is 30nm∼100nm.

The upper electrode layer 50 is one of transparent conductive layers of AZO, BZO, ITO. A thickness of the upper electrode layer 50 may not be limited, and in some embodiments, it is 100nm∼1µm.

In some embodiments of the present disclosure, other functional layers such as a zinc oxide layer and a zinc magnesium oxide layer can be added between any two of the back electrode layer, the light absorption layer, the buffer layer, and the upper electrode layer to facilitate close cohesion between layers and help the absorption and conversion of light.

Referring to Fig. 2, some embodiments of the present disclosure further provide a preparation method of a thin film solar battery. The preparation method comprises the following steps:
a) providing a substrate 10, forming a back electrode layer 20 on the substrate 10, and performing a first etching of the back electrode layer 20 to form on the back electrode layer 20 a plurality of first grooves 60 passing through the back electrode layer 200;
b) forming an insulator 70 in each of the plurality of first grooves 60, thereby forming a plurality of insulators;
c) forming a light absorption layer 30 and a buffer layer 40 sequentially on a surface of the back electrode layer 20 formed with the plurality of insulators 70, performing a second etching of the light absorption layer 30 and the buffer layer 40 to form a plurality of second grooves 80 passing through the light absorption layer 30 and the buffer layer 40; and
d) forming an upper electrode layer 50 on a surface of the buffer layer 40, the upper electrode layer 50 extending to the plurality of second grooves 80, and performing a third etching of the upper electrode layer 50, the buffer layer 40, and the light absorption layer 30 to form a plurality of third grooves 90 passing through the upper electrode layer 50, the buffer layer 40, and the light absorption layer 30, so as to obtain a plurality of serially connected battery cells.

For the description of the light absorption layer 30, reference can be made to the descriptions of the first light absorption layer 31 and the second light absorption layer 32. For the description of the buffer layer 40, reference can be made to the descriptions of the first buffer layer 41 and the second buffer layer 42. For the description of the upper electrode layer 50, reference can be made to the descriptions of the first upper electrode layer 51 and the second upper electrode layer 52. These will not be elaborated here.

In step a), the method for forming the back electrode layer 20 may be a method of chemical vapor deposition, magnetron sputtering, and atomic layer deposition, etc. After the first etching, the back electrode layer 20 can be divided into a plurality of "sub back electrode layers" disposed in interval which are similar to the first back electrode layer 21, the second back electrode layer 22, etc. The "sub back electrode layers", for example, are the first back electrode layer 21 and the second back electrode layer 22 as shown in Fig. 1. The second and third etching in steps c) and d) are to engrave the light absorption layer 30, the buffer layer 40, and the upper electrode layer 50 to form battery cells relatively independent from and serially connected with each other. The first battery cell 100 and the second battery cell 200 shown in Fig. 1 are named for the purpose of better explaining the relationship between the elements in the two adjacent battery cells. In fact, the first battery cell 100 and the elements thereof have the same structures as the second battery cell 200 and the elements thereof.

In step b), a mask is provided (not shown in the drawings), and an insulator 70 is formed in the first groove 60 through the mask. The method for forming the insulator 70 may be any method of magnetron sputtering, spin coating, spraying and chemical vapor deposition. The process of the method of spin coating and spraying is as follows: mixing insulating materials and solvents such as ethanol or water to obtain a mixture, then spin coating or spraying the mixture, and then drying the mixture to obtain the insulator 70. In some embodiments, the insulation section 70 is formed in the method of magnetron sputtering.

In step c), a second etching is performed to the light absorption layer 30 and the buffer layer 40 to form the second groove 80. The second groove 80 formed by the second etching may partially overlap the first groove 60 formed by the first etching; the second groove 80 may be also isolated from the first groove 60, i.e., they do not overlap. In some embodiments, the second groove 80 and the first groove 60 partially overlap, i.e., partial surface of the insulator 70 is made to be exposed by the second groove 80.

A width of the insulator 70 is expressed by m. A width of the portion of the insulator 70 that is exposed through the second groove 80 is expressed by d1, and in some embodiments of the present disclosure, the width m of the insulator 70 is greater than d1, e.g. m-d1≥30µm.

In steps a), c), and d), the first, second, and third etching can all be implemented through mechanical or laser etching. In some embodiments of the present disclosure, the method of the first etching is laser etching; the second and third etching are mechanical etching. Widths of the openings of the formed first groove 60, second groove 80, and third groove 90 are not limited. In some embodiments of the present disclosure, widths of the second groove 80 and the third groove 90 may be 60µm∼80µm. In some other embodiments of the present disclosure, the spacing distance between the second groove 80 and the third groove 90 is greater than 30µm.

The thin film solar battery and the preparation method thereof have the following advantages:
Since the first groove 60 formed by the first etching is provided with the insulator 70, i.e., the back electrode layers in a plurality of battery cells are disposed in interval by the insulators 70, thereby the second etching can be performed above a partial surface of the insulators 70. The second etching forms the second groove 80, the insulator 70 can be made to be exposed by the second groove 80; the spacing distance between the position of the second etching and the position of the first etching is reduced, and accordingly the area of the dead zone is greatly reduced, and thereby the conversion efficiency of the thin film solar battery is greatly improved.

This preparation method has the advantages of simple process, high efficiency, and controllability.

The thin film solar battery and the preparation method thereof are further described below with reference to the illustrative examples.

### Example 1

Example 1 provides a thin film solar battery and a preparation method thereof. The preparation method of the thin film solar battery is as follows:
a) providing a substrate and forming a back electrode layer thereon via the method of magnetron sputtering, and performing a first etching of the back electrode layer to form on the back electrode layer a plurality of first grooves passing through the back electrode layer.
   The material of the substrate is glass, the back electrode layer is a metal Mo layer, and parameters in the method of magnetron sputtering are as follows: taking argon as a gas source and metal Mo as a target material, the vacuum degree being 0.1Pa∼0.7Pa; the first etching is laser etching, and the width of the first groove is about 60µm;
b) providing a mask, and forming a plurality of insulators made from Si₃N₄ in the plurality of first grooves in one-to-one correspondence via the method of magnetron sputtering;
c) forming a light absorption layer and a buffer layer sequentially on a surface of the back electrode layer formed with the plurality of insulators, performing a second etching of the light absorption layer and the buffer layer to form a plurality of second grooves passing through the light absorption layer and the buffer layer, wherein the second etching is mechanical etching, the width of the second groove formed by the second etching is about 50µm, the width d1 of the portion of the insulator that is made to be exposed by the second groove is about 30µm, the light absorption layer is a copper indium gallium selenide compound layer having a thickness of about 3µm, and the buffer layer is a cadmium sulfide layer having a thickness of about 80nm;
d) forming an upper electrode layer on a surface of the buffer layer, the upper electrode layer extending to the second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells, wherein the third etching is mechanical etching, the spacing distance (i.e., the distance between right border of the second groove and left border of the adjacent third groove) between the third groove and the second groove is 40µm, the upper electrode layer is an AZO transparent thin conductive film having a thickness of about 800nm, and the width of the third groove is about 60µm.

The width between the first groove and the third groove (i.e., the width between left border of the first groove and right border of the adjacent third groove, the same below) in the obtained thin film solar battery is about 180µm.

### Example 2

Example 2 provides a thin film solar battery and a preparation method thereof. The preparation method of the thin film solar battery is as follows:
a) providing a substrate and forming a back electrode layer thereon via the method of magnetron sputtering, and performing a first etching of the back electrode layer to form on the back electrode layer a plurality of first grooves passing through the back electrode layer.
   The material of the substrate is glass, the back electrode layer is a metal Mo layer, and parameters in the method of magnetron sputtering are as follows: taking argon as a gas source and metal Mo as a target material, the vacuum degree being 0.1Pa∼0.7Pa; the first etching is laser etching, and the width of the first groove is about 50µm;
b) providing a mask, and forming a plurality of insulators made from Si₃N₄ in the plurality of first grooves in one-to-one correspondence via the method of magnetron sputtering;
c) forming a light absorption layer and a buffer layer sequentially on a surface of the back electrode layer formed with the plurality of insulators, performing a second etching of the light absorption layer and the buffer layer to form a plurality of second grooves passing through the light absorption layer and the buffer layer, wherein the second etching is mechanical etching, the width of the second groove is about 70µm,the width d1 of the portion of the insulator that is made to be exposed by the second groove is about 15µm, the light absorption layer is a copper indium gallium selenide compound layer having a thickness of about 3µm, and the buffer layer is a cadmium sulfide layer having a thickness of about 80nm;
d) forming an upper electrode layer on a surface of the buffer layer, the upper electrode layer extending to the second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells, wherein the third etching is mechanical etching, the spacing distance between the third groove and the second groove is 40µm, the upper electrode layer is an AZO transparent thin conductive film having a thickness of about 30µm, and the width of the third groove is about 70µm.

The preparation method of a thin film solar battery in Example 2 is substantially the same as that in Example 1, and their difference lies in the width d1 of the portion of the insulator that is made to be exposed by the second groove, and the widths of the first, second and third grooves.

The width between the first groove and the third groove in the obtained thin film solar battery is about 215µm.

### Example 3

Example 3 provides a thin film solar battery and a preparation method thereof. The preparation method of the thin film solar battery is as follows:
a) providing a substrate and forming a back electrode layer thereon via the method of magnetron sputtering, and performing a first etching of the back electrode layer to form on the back electrode layer a plurality of first grooves passing through the back electrode layer.
   The material of the substrate is glass, the back electrode layer is a metal Mo layer, and parameters in the method of magnetron sputtering are as follows: taking argon as a gas source and metal Mo as a target material, the vacuum degree being 0.1Pa∼0.7Pa; the first etching is laser etching, and the width of the first groove is about 40µm;
b) providing a mask, and forming a plurality of insulators made from Si₃N₄ in the plurality of first grooves in one-to-one correspondence via the method of magnetron sputtering;
c) forming a light absorption layer and a buffer layer sequentially on a surface of the back electrode layer formed with the plurality of insulators, performing a second etching of the light absorption layer and the buffer layer to form a plurality of second grooves passing through the light absorption layer and the buffer layer, wherein the second etching is mechanical etching, the width of the second groove is about 80µm, the width d1 of the portion of the insulator that is made to be exposed by the second groove is about 5µm, the light absorption layer is a copper indium gallium selenide compound layer having a thickness of about 3µm, and the buffer layer is a cadmium sulfide layer having a thickness of about 80nm;
d) forming an upper electrode layer on a surface of the buffer layer, the upper electrode layer extending to the second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells, wherein the third etching is mechanical etching, the spacing distance between the third groove and the second groove is 40µm, the upper electrode layer is an AZO transparent thin conductive film having a thickness of about 30µm, and the width of the third groove is about 80µm.

The preparation method of a thin film solar battery in Example 3 is substantially the same as that in Example 1, but the width d1 of the portion of the insulator that is made to be exposed by the second groove, and the widths of the first, second and third grooves are different.

The width between the first groove and the third groove in the obtained thin film solar battery is about 235µm.

### Example 4

Example 4 provides a thin film solar battery and a preparation method thereof. The preparation method of the thin film solar battery is as follows:
a) providing a substrate and forming a back electrode layer thereon via the method of magnetron sputtering, and performing a first etching of the back electrode layer to form on the back electrode layer a plurality of first grooves passing through the back electrode layer.
   The material of the substrate is glass, the back electrode layer is a metal Mo layer, and parameters in the method of magnetron sputtering are as follows: taking argon as a gas source and metal Mo as a target material, the vacuum degree being 0.1Pa∼0.7Pa; the first etching is laser etching, and the width of the first groove is about 40µm;
b) providing a mask, and forming a plurality of insulators made from Si₃N₄ in the plurality of first grooves in one-to-one correspondence via the method of magnetron sputtering;
c) forming a light absorption layer and a buffer layer sequentially on a surface of the back electrode layer formed with the plurality of insulators, performing a second etching of the light absorption layer and the buffer layer to form a plurality of second grooves passing through the light absorption layer and the buffer layer, wherein the second etching is mechanical etching, the width of the second groove is about 60µm, the insulator is not exposed from the second groove (i.e., the width d1 of the portion of the insulator that is made to be exposed by the second groove is 0), the spacing distance between the second groove and the first groove is 10µm, the light absorption layer is a copper indium gallium selenide compound layer having a thickness of about 3µm, and the buffer layer is a cadmium sulfide layer having a thickness of about 80nm;
d) forming an upper electrode layer on a surface of the buffer layer, the upper electrode layer extending to the second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells, wherein the third etching is mechanical etching, the spacing distance between the third groove and the second groove is 40µm, the upper electrode layer is an AZO transparent thin conductive film having a thickness of about 30µm, and the width of the third groove is about 60µm.

The preparation method of a thin film solar battery in Example 4 is substantially the same as that in Example 1, but in Example 4, the position of the first etching is isolated from the position of the second etching, i.e., in step c) of Example 4, after the second etching, the insulator is not exposed by the second groove. In addition, the width of the first groove in Example 4 is also different from that in Example 1.

The width between the first groove and the third groove in the obtained thin film solar battery is about 210µm.

To better demonstrate the excellent performance of the thin film solar battery in the present disclosure, the present disclosure also provides a comparative example.

### Comparative example

This comparative example provides a thin film solar battery and a preparation method thereof. The preparation method of the thin film solar battery is as follows:
a) providing a substrate and forming a back electrode layer thereon via the method of magnetron sputtering, and performing a first etching of the back electrode layer to form on the back electrode layer a plurality of first grooves passing through the back electrode layer.
   The material of the substrate is glass, the back electrode layer is a metal Mo layer, and parameters in the method of magnetron sputtering are as follows: taking argon as a gas source and metal Mo as a target material, the vacuum degree being 0.1Pa∼0.7Pa; the first etching is laser etching, and the width of the first groove is about 60µm;
b) forming a light absorption layer and a buffer layer sequentially on a surface of the back electrode layer formed with a plurality of first grooves, performing a second etching of the light absorption layer and the buffer layer to form a plurality of second grooves passing through the light absorption layer and the buffer layer, wherein the second etching is mechanical etching, the width of the second groove is about 60µm, the spacing distance between the second groove and the first groove is 40µm, the light absorption layer is a copper indium gallium selenide compound layer having a thickness of about 3µm, and the buffer layer is a cadmium sulfide layer having a thickness of about 80nm;
c) forming an upper electrode layer on a surface of the buffer layer, the upper electrode layer extending to the second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells, wherein the third etching is mechanical etching, the upper electrode layer is an AZO transparent thin conductive film having a thickness of about 800nm, the width of the third groove is about 60µm, and the spacing distance between the third groove and the second groove is 40µm.

The preparation method of thin film solar battery in this comparative example is substantially the same as that in Example 4, and their difference lies in that the comparative example does not include the step of forming an insulator in the first groove, i.e., in this comparative example, the light absorption layer is formed directly on the back electrode layer, i.e., the first groove is filled with the light absorption layer.

The width between the first groove and the third groove in the obtained thin film solar battery is about 260µm. As can be seen, compared with Example 1, the comparative example has a larger area of dead zone. As can be seen from the above Examples 1∼4, the area of the dead zone of the thin film solar battery can be greatly reduced; therefore, the photoelectric conversion efficiency of the thin film solar battery can be significantly improved in use.

The widths of the above-described 3 grooves can be adjusted according to the implementation process, and is not limited to the above sizes, and the technical features in the above embodiments can be combined in any combination. To make the description concise, not all possible combinations of the technical features in the above embodiments are described, but all of them shall be considered within the scope of disclosure of the specification, as long as they do not conflict with each other. The above embodiments are merely some of embodiments of the present disclosure, and the description is specific and detailed, but it should not be understood thereby that they constitute a limitation to the patent scope of the present disclosure. It should be noted that for persons with common skill in the art, various changes and modifications can be made therein without departing from the spirit and essence of the disclosure, which are also considered to be within the scope of the disclosure. Therefore, the protection scope of the patent of the present disclosure shall be determined by the appended claims.

## Claims

1. A preparation method of a thin film solar battery, comprising:
a) providing a substrate and forming a back electrode layer thereon, and performing a first etching of the back electrode layer to form a plurality of first grooves on the back electrode layer, the plurality of first grooves all passing through the back electrode layer;
b) forming an insulator in each of the plurality of first grooves, thereby forming a plurality of insulators;
c) forming a light absorption layer and a buffer layer sequentially on a surface of the back electrode layer formed with the plurality of insulators, performing a second etching of the light absorption layer and the buffer layer to form a plurality of second grooves, the plurality of second grooves all passing through the light absorption layer and the buffer layer; and
d) forming an upper electrode layer on a surface of the buffer layer, the upper electrode layer extending to the plurality of second grooves, and performing a third etching of the upper electrode layer, the buffer layer, and the light absorption layer to form a plurality of third grooves passing through the upper electrode layer, the buffer layer, and the light absorption layer, so as to obtain a plurality of serially connected battery cells.

2. The preparation method of a thin film solar battery according to Claim 1, wherein positions of the plurality of second grooves are configured such that
a portion of the back electrode layer is exposed from a bottom of each of the plurality of second grooves.

3. The preparation method of a thin film solar battery according to Claim 1, wherein positions of the plurality of second grooves are configured such that
a portion of the back electrode layer and a portion of one of the plurality of insulators are exposed from a bottom of each of the plurality of second grooves.

4. The preparation method of a thin film solar battery according to Claim 3, wherein
when one of the plurality of first grooves isolates a back electrode layer of a first battery cell from a back electrode layer of a second battery cell adjacent to the first battery cell, and is filled with a insulator,
a portion of the insulator of the first battery cell and a portion of the back electrode layer of the second battery cell are exposed from a bottom of one of the plurality of second grooves that passes through the light absorption layer and the buffer layer of the first battery cell;
the upper electrode layer of the first battery cell covers a portion of the insulator of the first battery cell and a portion of the back electrode layer of the second battery cell.

5. The preparation method of a thin film solar battery according to Claim 1, wherein forming an insulator in each of the plurality of first grooves thereby forming a plurality of insulators in step b) is as follows: providing a mask, and forming the plurality of insulators in the plurality of first grooves in one-to-one correspondence via the mask.

6. The preparation method of a thin film solar battery according to Claim 5, wherein a method for forming the plurality of insulators is any method of magnetron sputtering, spin coating, spraying and chemical vapor deposition.

7. The preparation method of a thin film solar battery according to Claim 1, wherein material of each of the insulator is at least one of Si₃N₄, AlN, SiO₂, and Al₂O₃.

8. The preparation method of a thin film solar battery according to Claim 3, wherein a width of each of the plurality of insulators is expressed by m, a width of the portion of the each of the plurality of insulators that is exposed by a corresponding second groove is expressed by d1, and m and d1 satisfy the condition below: m>d1>0.

9. The preparation method of a thin film solar battery according to Claim 1, wherein at least one zinc oxide layer is arranged between the back electrode layer and the light absorption layer, or between the light absorption layer and the buffer layer, or between the buffer layer and the upper electrode layer.

10. The preparation method of a thin film solar battery according to Claim 1, wherein each of the plurality of second grooves and each of the plurality of third grooves have a width of 50µm∼80µm.

11. The preparation method of a thin film solar battery according to Claim 1, wherein a thickness of each of the plurality of insulators is greater than or equal to a thickness of the back electrode layer.

12. The preparation method of a thin film solar battery according to Claim 1, wherein material of the light absorption layer is any one of copper indium gallium selenium, copper indium selenium, and copper indium gallium sulfur.
